Europäisches Patentamt

European Patent Office

Office européen des brevets

(19)

(11) EP 0 910 093 A1

## (12) DEMANDE DE BREVET EUROPEEN

(43) Date de publication:
21.04.1999 Bulletin 1999/16

(51) Int Cl.⁶: **G11C 11/401**

(21) Numéro de dépôt: 98402477.8

(22) Date de dépôt: 06.10.1998

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: 14.10.1997 FR 9712818

(71) Demandeur: **STMicroelectronics SA**
**94250 Gentilly Cedex (FR)**

(72) Inventeur: **El Hajji, Noureddine**
**38100 Grenoble (FR)**

(74) Mandataire: **Casalonga, Axel**
**BUREAU D.A. CASALONGA - JOSSE**
**Morassistrasse 8**
**80469 München (DE)**

### (54) Dispositif de mémoire vive dynamique

(57) Chaque cellule-mémoire (CM) comprend quatre transistors à effet de champ à grilles isolées (T1-T4) comprenant deux transistors de mémorisation (T3, T4) possédant tous les deux un même premier quotient (W1/L1) entre leur largeur de canal (W1) et leur longueur de canal (L1), et deux transistors d'accès (T1, T2) possédant tous les deux un même deuxième quotient (W2/L2) entre leur largeur de canal (W2) et leur longueur de canal (L2). Le rapport (R) entre le premier quotient et le deuxième quotient est supérieur ou égal à un.

## FIG.1

# Description

L'invention concerne les mémoires vives dynamiques (DRAM : "Dynamic Random Access Memory" en langue anglaise).

Par opposition aux mémoires vives statiques (SRAM) dans lesquelles l'information mémorisée le reste indéfiniment du moins tant que ces mémoires restent alimentées, les mémoires dynamiques présentent la particularité de nécessiter un rafraîchissement périodique de l'information stockée en raison notamment des courants de fuites parasites qui déchargent la capacité de stockage de chaque cellule-mémoire (point-mémoire).

Ce rafraîchissement s'effectue classiquement au cours d'un cycle de lecture/ré-écriture nécessitant en conséquence une phase spécifique de ré-écriture de la donnée lue.

Parmi les cellule-mémoire connues de mémoire vive dynamique, on peut notamment citer celles comportant deux ou trois transistors et celles comportant un seul transistor dont la lecture de l'information détruit en outre cette dernière.

L'invention vise à proposer une structure radicalement différente de cellule-mémoire d'une mémoire vive dynamique, permettant notamment un rafraîchissement automatique de la donnée lue, ce rafraîchissement automatique ne nécessitant donc pas de phase spécifique de ré-écriture.

En outre, la lecture d'une donnée dans la cellule-mémoire selon l'invention ne détruit pas cette donnée.

L'invention a également pour but de proposer une structure de mémoire dont la surface occupée par les circuits nécessaires pour lire/écrire le plan mémoire ("overhead") est plus faible que celle des circuits correspondants associés aux mémoires vives dynamiques connues.

L'invention a également pour but de proposer une structure de mémoire utilisant un nombre moins important de niveaux de métallisation, ce qui diminue la probabilité de défaillance structurelle.

Telle que revendiquée, l'invention propose donc un dispositif de mémoire vive dynamique comportant des cellules-mémoire organisées en lignes et en colonnes, dans lesquelles chaque cellule-mémoire comprend quatre transistors à effet de champ à grille isolée. Ces quatre transistors se répartissent en deux transistors de mémorisation et en deux transistors d'accès. Les deux transistors de mémorisation possèdent tous les deux un même quotient entre leur largeur de canal $W1$ et leur longueur de canal $L1$, tandis que les deux transistors d'accès possèdent tous les deux un même quotient entre leur largeur de canal $W2$ et leur longueur de canal $L2$. Le rapport entre le premier quotient $W1/L1$ et le deuxième quotient $W2/L2$ est choisi supérieur ou égal à 1 et, de préférence supérieur ou égal à 2.

Comme on le verra plus en détail ci-après, la cellule-mémoire à quatre transistors selon l'invention peut être "rafraîchie", lue ou écrite. Mais en fait, le rafraîchissement s'opère au début du cycle de lecture de telle sorte que la cellule-mémoire est automatiquement rafraîchie lorsqu'elle est lue. Or, au cours de cette opération, un pic de tension apparaît du côté du noeud qui avait été porté au potentiel nul lors de l'écriture. Et, si ce pic de tension est trop important, la cellule-mémoire peut perdre sa donnée, rafraîchir dans le mauvais sens et finalement fournir en lecture une donnée erronée.

Le choix du rapport entre les deux quotients W/L mentionné plus haut permet d'éviter un tel dysfonctionnement.

Selon un mode de réalisation de l'invention, chaque cellule-mémoire comporte une première entrée et une deuxième entrée pour recevoir respectivement, lors des phases de lecture et d'écriture, deux tensions de commande (correspondant à la tension appliquée sur une première métallisation de colonne ou "ligne de bits" et sur une métallisation de colonne de référence immédiatement adjacente). Chaque cellule-mémoire comporte également une entrée de sélection pour recevoir une tension de sélection de ligne véhiculée par une métallisation spécifique de ligne ("ligne de mot" ou "wordline"). En outre, la source d'un premier transistor d'accès est relié à la première entrée tandis que la source du deuxième transistor d'accès est reliée à la deuxième entrée. Le drain du premier transistor d'accès est relié au drain d'un premier transistor de mémorisation et à la grille du deuxième transistor de mémorisation, tandis que le drain du deuxième transistor d'accès est relié au drain du deuxième transistor de mémorisation et à la grille du premier transistor de mémorisation. Les sources des deux transistors de mémorisation sont reliées ensemble à une première tension de polarisation (par exemple la masse lorsqu'il s'agit de transistors NMOS ou bien la tension de niveau élevé VDD lorsqu'il s'agit de transistors PMOS). Enfin, les grilles des deux transistors d'accès sont reliées à l'entrée de sélection et par conséquent à la ligne de mot ("wordline").

Les quatre transistors peuvent être des transistors NMOS ou bien des transistors PMOS.

Pour diminuer les courants de fuite à travers notamment le chemin drain-source des transistors de mémorisation, et donc pour améliorer le temps de rétention de la donnée mémorisée, on peut polariser de façon appropriée le substrat de tous les transistors de façon à obtenir, en utilisant "l'effet substrat", une augmentation de la tension de seuil et par conséquent une augmentation de temps de rétention. Au sens de l'invention, le terme "substrat" ("bulk" en langue anglaise) désigne le substrat proprement dit lorsque le transistor n'est pas disposé dans un caisson, ou bien le caisson s'il en existe un.

Plus précisément, dans le cas de transistors NMOS, on polarisera avantageusement le caisson négativement tandis que dans le cas de transistors PMOS, on polarisera avantageusement le caisson à une tension supérieure à la tension VDD.

Plus généralement, on relie de préférence les substrats de tous les transistors à une deuxième tension de polarisation prédéterminée et l'on choisit les première et deuxième tensions de polarisation de telle sorte que la différence entre la deuxième tension de polarisation et la première tension de polarisation soit négative ou nulle dans le cas de transistors NMOS, tout en restant supérieure à l'opposé de la tension de seuil des transistors. Dans le cas des transistors PMOS, la différence entre la deuxième tension de polarisation et la première tension de polarisation est choisie positive ou nulle tout en restant inférieure à la somme de la première tension de polarisation et de la tension de seuil des transistors.

D'autres avantages et caractéristiques de l'invention apparaîtront à l'examen de la description détaillée d'un mode de réalisation, nullement limitatif et des dessins annexés sur lesquels :

- la figure 1 est une représentation schématique d'une cellule-mémoire selon l'invention réalisée à partir de transistors NMOS, et,
- la figure 2 illustre schématiquement un cycle de lecture de la cellule, comportant un rafraîchissement automatique de la donnée mémorisée.

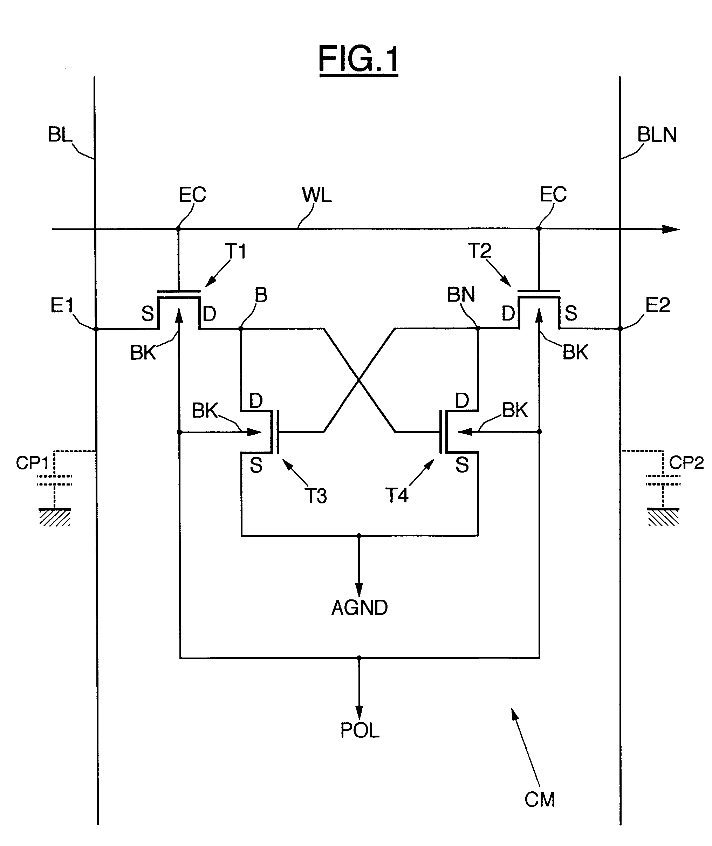

Sur la figure 1, on n'a représenté à des fins de simplification qu'une seule cellule-mémoire CM. Bien entendu, l'homme du métier sait que ces cellules-mémoire sont organisées en lignes et en colonnes de façon à former le plan mémoire de la mémoire vive dynamique.

Plus précisément, chaque cellule-mémoire comporte deux entrées E1 et E2 respectivement connectées sur deux métallisations adjacentes de colonnes BL et BLN, pour recevoir des tensions de commande pour la lecture et l'écriture de la donnée mémorisée dans la cellule-mémoire.

Par ailleurs, de façon classique, chaque cellule-mémoire est sélectionnée par un signal WL véhiculé par une métallisation de ligne ou "ligne de mot" ("wordline"). A cet égard, la cellule-mémoire CM comporte deux transistors d'accès NMOS, respectivement référencés T1 et T2 dont les grilles respectives sont connectées sur la ligne de mot, les noeuds correspondants EC formant ainsi une entrée de sélection pour cette cellule-mémoire.

Outre les deux transistors d'accès T1 et T2, la cellule-mémoire CM comporte deux transistors NMOS de mémorisation T3 et T4. La capacité de stockage de la donnée mémorisée est formée par la capacité grille/source d'un transistor de mémorisation.

La grille du transistor T4 ainsi que le drain du transistor T3 sont reliés au drain du transistor d'accès T1, le noeud correspondant étant référencé B.

De même, la grille du transistor de mémorisation T3 ainsi que le drain du transistor de mémorisation T4 sont reliés au drain du transistor d'accès T2 le noeud correspondant étant référencé BN

Les sources respectives et transistors d'accès T1 et T2 sont respectivement reliés aux deux entrées de commande E1 et E2.

Enfin, les sources des deux transistors de mémorisation T3 et T4 sont reliées ensemble à une première tension de polarisation prédéterminée AGND.

Par ailleurs, le substrat BK de chaque transistor de la cellule-mémoire, ou bien le caisson BK de ce transistor si celui-ci est encaissonné, est avantageusement relié à une deuxième tension de polarisation POL.

Ceci étant, il est particulièrement avantageux que les transistors de la cellule-mémoire CM soient disposés dans un caisson (voire dans un double caisson) réalisé au sein d'un substrat semiconducteur. Ce mode de réalisation présente l'avantage d'offrir moins de fuites de courants, d'être moins sensible au "bruit" provenant du substrat, et d'être moins sensible aux particules alpha.

Afin de limiter les pertes de charge des capacités de stockage des transistors de mémorisation, et par conséquent pour augmenter le temps de rétention d'une donnée mémorisée, on choisit avantageusement les tensions POL et AGND de telle sorte que ces tensions vérifient la relation suivante :

$$- VT \leq POL - AGND \leq 0$$

dans laquelle VT désigne la tension de seuil des transistors.

En effet, une telle relation entre la tension POL et la tension AGND conduit à une différence de potentiel "source-substrat" positive ce qui, compte tenu de "l'effet substrat" bien connu de l'homme du métier, conduit à une augmentation de la tension de seuil et par conséquent à une augmentation du temps de rétention.

Dans l'exemple décrit ci-dessus, avec une technologie $0,35\mu$, et une tension AGND nulle, on choisira une tension POL sensiblement égale à -VDD/10 c'est à dire sensiblement égale à - 0,3 V.

Dans le cas où la cellule-mémoire est réalisée à partir de transistors PMOS, la tension de polarisation AGND est alors remplacée par la tension de polarisation AVDD, par exemple 3 V. Dans ce cas, toujours pour augmenter le temps de rétention de la donnée par utilisation de "l'effet substrat", on choisira les tensions AVDD et POL de façon à ce que :

$$VDD+VT \geq POL - AVDD \geq 0$$

Pour illustrer le fonctionnement de la cellule-mémoire CM en écriture, on suppose que l'on souhaite écrire un "1" logique.

On sélectionne la cellule CM en activant le signal logique WL (WL = 1) et on applique sur les métallisations BL et BLN des tensions respectivement égales à VDD et 0.

Puisque les transistors d'accès T1 et T2 sont passants, la tension au noeud B est égale à VDD - VT tandis que la tension au noeud BN est nulle. Le transistor de mémorisation T3 est donc bloqué tandis que le transistor de mémorisation T4 est passant. La valeur "1" logique est par conséquent mémorisée dans la capacité grille-source du transistor T4. Il convient de noter ici que puisque le transistor T3 est bloqué, la tension au noeud B tend à garder sa valeur haute (si l'on fait abstraction bien sûr des fuites de courants parasites). De même, puisque le transistor T4 est passant, la tension au noeud BN tend à être maintenue à son niveau nul. En conséquence, l'homme du métier remarque ici le caractère de stabilité de la cellule-mémoire lors de la phase d'écriture. Ensuite, on désactive le signal WL, la donnée est alors considérée comme écrite.

Pour l'écriture d'un "0" logique, on applique une tension nulle sur la métallisation BL et une tension de niveau élevé (VDD) sur la métallisation BLN, C'est alors la capacité grille-source du transistor T3 qui stocke une charge résultant de l'application de la tension de niveau élevé au noeud BN.

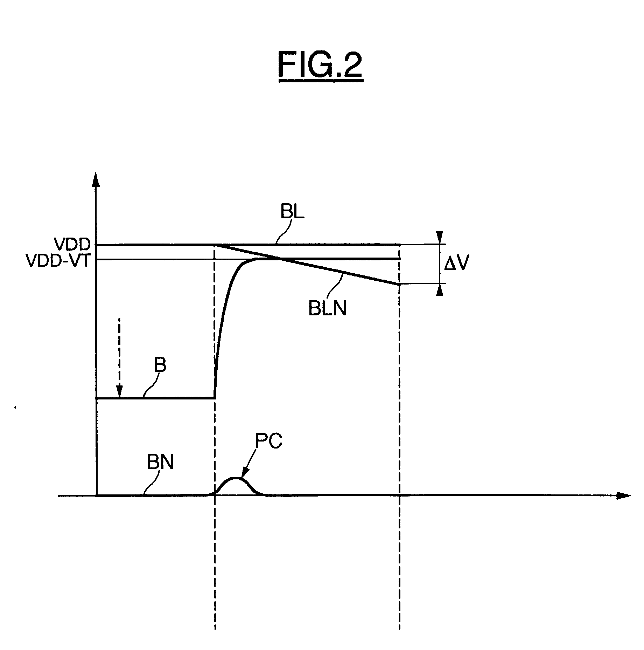

On se réfère maintenant plus particulièrement à la figure 2 pour illustrer le fonctionnement de la cellule-mémoire en mode de lecture.

On suppose dans l'exemple qui va être décrit qu'un "1" logique a été préalablement mémorisé dans la cellule-mémoire.

D'une façon classique, la première étape consiste à précharger les métallisations BL et BLN à un niveau élevé de tension, en l'espèce VDD si le circuit de précharge comporte des transistors PMOS ou bien à VDD - VT si le circuit de précharge comporte des transistors NMOS.

On suppose également, qu'en raison des fuites dans le substrat, le potentiel au noeud B a subi une chute de tension par rapport au niveau initial VDD - VT qui lui a été appliqué lors de l'écriture de la donnée logique.

Après désactivation de la précharge, on active le signal WL de sélection de ligne, ce qui a pour effet de rendre passants les deux transistors d'accès T1 et T2.

En conséquence, il se produit immédiatement un transfert de la charge de la capacité parasite CP1 de la métallisation BL vers le noeud B ce qui a pour effet de porter le potentiel de ce noeud B à sa valeur initiale VDD - VT. La durée de transfert est d'autant plus courte que le rapport entre la capacité de mémorisation grille/source et la capacité parasite CP1 (ou CP2) est faible, par exemple inférieur à 1/50. Ceci étant sur la figure 2, la durée de transfert de charge a été volontairement exagérée. L'homme du métier remarque donc que la cellule-mémoire selon l'invention présente la propriété remarquable de voir la donnée mémorisée automatiquement et quasi immédiatement rafraîchie au début d'un cycle de lecture. Il n'est donc pas nécessaire de prévoir un cycle spécifique de lecture ré-écriture pour rafraîchir la donnée mémorisée.

Par ailleurs, après activation du signal WL, il se produit une décroissance du potentiel de la métallisation BLN par rapport au potentiel de la métallisation BL ce qui conduit à une différence de potentiel ΔV dont la lecture du signe permet de déterminer la valeur logique de la donnée mémorisée dans la cellule-mémoire.

Lors de l'activation du signal WL, il se produit transitoirement un pic de tension PC au niveau du noeud BN. Il est indispensable ici d'éviter que ce pic de tension soit trop important et en particulier qu'il soit supérieur ou égal à la tension de seuil des transistors de mémorisation de façon à éviter que le transistor T3 ne devienne passant ce qui aurait pour effet alors de faire chuter la tension au noeud B et de bloquer le transistor T4 pour conduire finalement à une perte de l'information mémorisée, à un rafraîchissement de la donnée dans le "mauvais sens" et par conséquent à la lecture d'une donnée de valeur logique inverse de celle qui avait été préalablement écrite.

C'est pourquoi, il est nécessaire que le rapport

$$\mathbf{R} = \frac{\mathbf{W1}}{\mathbf{L1}} \Big/ \frac{\mathbf{W2}}{\mathbf{L2}}$$

soit supérieur ou égal à 1 et de préférence supérieur ou égal à 2

(W1 et L1 désignant respectivement les largeur et longueur de canal des transistors de mémorisation tandis que W2 et L2 désignent les largeur et longueur de canal des transistors d'accès; la longueur correspond à la distance drain-source).

A titre indicatif pour une technologie CMOS 0,35μ, on choisira de préférence W1 = 1,4μ, L1 = 0,4μ, W2 = 0,8μ et L2 = 0,5μ ce qui conduit à un rapport R de l'ordre de 2,2.

La durée du cycle de lecture d'une telle cellule-mémoire est typiquement de l'ordre de 30ns tandis que la durée de rafraîchissement de l'information est beaucoup plus courte, typiquement de l'ordre de 5ns pour une capacité de mémorisation grille/source de l'ordre de quelques fentofarad et une capacité parasite de ligne de bit de l'ordre de quelques centaines de fentofarad. Dans ces conditions, la structure de mémoire selon l'invention permet avantageusement d'utiliser des cycles spécifiques de rafraîchissement extrêmement courts.

Par ailleurs, la cellule-mémoire selon l'invention ne nécessite pas de procédé dédié de fabrication pour la réalisation de condensateurs de stockage, et ne nécessite que trois niveaux de métallisation pour sa réalisation en circuit intégré, alors qu'une cellule-mémoire à un transistor nécessite cinq niveaux de métallisation.

## Revendications

1. Dispositif de mémoire vive dynamique, comportant des cellules-mémoire organisées en lignes et en colonnes, caractérisé par le fait que chaque cellule-mémoire (CM) comprend quatre transistors à effet de champ à grilles isolées (T1-T4) comprenant deux transistors de mémorisation (T3, T4) possédant tous les deux un même premier quotient (W1/L1) entre leur largeur de canal (W1) et leur longueur de canal (L1), et deux transistors d'accès (T1, T2) possédant tous les deux un même deuxième quotient (W2/L2) entre leur largeur de canal (W2) et leur longueur de canal (L2), et par le fait que le rapport (R) entre le premier quotient et le deuxième quotient est supérieur ou égal à un.

2. Dispositif selon la revendication 1, caractérisé par le fait que le rapport est supérieur ou égal à deux.

3. Dispositif selon l'une des revendications précédentes, caractérisé par le fait que chaque cellule-mémoire (CM) comporte une première entrée (E1) et une deuxième entrée (E2) pour recevoir respectivement, lors des phases de lecture et d'écriture, deux tensions de commande (BL, BLN), une entrée de sélection (EC) pour recevoir une tension de sélection de ligne (WL), et par le fait que la source d'un premier transistor d'accès (T1) est reliée à la première entrée (E1) tandis que la source du deuxième transistor d'accès (T2) est reliée à la deuxième entrée (E2), par le fait que le drain du premier transistor d'accès (T1) est relié au drain d'un premier transistor de mémorisation (T3) et à la grille du deuxième transistor de mémorisation (T4), tandis que le drain du deuxième transistor d'accès (T2) est relié au drain du deuxième transistor de mémorisation (T4) et à la grille du premier transistor de mémorisation (T3), par le fait que les sources des deux transistors de mémorisation sont reliées ensemble à une première tension de polarisation (AGND), et par le fait que les grilles des deux transistors d'accès sont reliées à l'entrée de sélection (EC).

4. Dispositif selon l'une des revendications précédentes, caractérisé par le fait que les quatre transistors sont des transistors NMOS.

5. Dispositif selon la revendication 4, caractérisé par le fait que les substrats (BK) des transistors sont tous reliés à une deuxième tension de polarisation prédéterminée (POL), et par le fait que la différence entre la deuxième tension de polarisation (POL) et la première tension de polarisation (AGND) est négative ou nulle et supérieure à l'opposé de la tension de seuil des transistors.

6. Dispositif selon l'une des revendications 1 à 3, caractérisé par le fait que les quatre transistors sont des transistors PMOS.

7. Dispositif selon la revendication 6, caractérisé par le fait que les substrats des transistors sont tous reliés à une deuxième tension de polarisation prédéterminée (POL), et par le fait que la différence entre la deuxième tension de polarisation (POL) et la première tension de polarisation (AVDD) est positive ou nulle et inférieure à la somme de la première tension de polarisation (AVDD) et de la tension de seuil des transistors.

8. Dispositif selon l'une des revendications précédentes, caractérisé par le fait que les quatre transistors sont disposés dans au moins un caisson (BK).

9. Dispositif selon l'une des revendications précédentes, caractérisé par le fait que le rapport entre la capacité parasite (CP1, CP2) de la métallisation de colonne (BL, BLN) et la capacité grille/source d'un transistor de mémorisation est au moins égal à 50.

# FIG.1

EP 0 910 093 A1

# FIG.2

7

Office européen
des brevets

**RAPPORT DE RECHERCHE EUROPEENNE**

Numéro de la demande

EP 98 40 2477

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | EP 0 681 331 A (TEXAS INSTRUMENTS INC) 8 novembre 1995 * le document en entier * | 1-8 | G11C11/401 |
| A | US 4 023 149 A (BORMANN ALAN R ET AL) 10 mai 1977 * le document en entier * | 1-4 | |

**DOMAINES TECHNIQUES RECHERCHES (Int.Cl.6)**

G11C

Le présent rapport a été établi pour toutes les revendications

| Lieu de la recherche | Date d'achèvement de la recherche | Examinateur |
|---|---|---|
| LA HAYE | 4 janvier 1999 | Beasley-Suffolk, D |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

    ........................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 98 40 2477

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-01-1999

| Document brevet cité au rapport de recherche | Date de publication | Membre(s) de la famille de brevet(s) | Date de publication |
|---|---|---|---|
| EP 0681331 A | 08-11-1995 | US 5595925 A<br>JP 8008412 A | 21-01-1997<br>12-01-1996 |
| US 4023149 A | 10-05-1977 | AUCUN | |

Pour tout renseignement concernant cette annexe : voir Journal Officiel de l'Office européen des brevets, No.12/82